**Europäisches Patentamt**

**European Patent Office**

**Office européen des brevets**

(19)

(11) Publication number : **0 365 589 B1**

# EUROPEAN PATENT SPECIFICATION

(12)

(45) Date of publication of patent specification :
23.09.92 Bulletin 92/39

(51) Int. Cl.⁵ : **B65G 47/14**

(21) Application number : **88906274.1**

(22) Date of filing : **23.05.88**

(86) International application number :
**PCT/US88/01728**

(87) International publication number :
**WO 88/09303 01.12.88 Gazette 88/26**

(54) **METHOD AND APPARATUS FOR ALIGNING SILICON WAFERS.**

(30) Priority : **21.05.87 US 52496**

(43) Date of publication of application :
**02.05.90 Bulletin 90/18**

(45) Publication of the grant of the patent :
**23.09.92 Bulletin 92/39**

(84) Designated Contracting States :
**BE CH DE FR GB IT LI NL SE**

(56) References cited :
**WO-A-84/04739
GB-A- 2 171 978
US-A- 3 160 295
US-A- 3 820 647**

(56) References cited :
**US-A- 4 094 426
US-A- 4 427 332
US-A- 4 449 885
US-A- 4 655 584
US-A- 4 662 811
US-A- 4 691 817**

(73) Proprietor : **HINE DESIGN INC.
1901 Embarcadero Road Unit 104
Palo Alto, CA 94303 (US)**

(72) Inventor : **HINE, Derek, L.
5 Hawk View
Portola Valley, CA 94025 (US)**

(74) Representative : **Prüfer, Lutz H., Dipl.-Phys.
Harthauser Strasse 25d
W-8000 München 90 (DE)**

Jouve, 18, rue Saint-Denis, 75001 PARIS

EP 0 365 589 B1

## Description

This invention relates to methods for transporting silicon wafers, in particular such methods in which the wafer is aligned, and apparatus which is suitable for use in such methods.

In the manufacture of solid state devices, silicon wafers are moved between different work stations, often in cassettes which hold a number of spaced-apart wafers stacked next to each other in pockets. Many processes require that the wafer is precisely aligned. The alignment required may be the precise positioning of the center of the wafer and/or the precise orientation of the wafer relative to its crystalline plane, which is indicated on the wafer by a marker of some kind, usually a flat or notch on the perimeter of the wafer. The transporting of individual wafers (including in particular their removal from cassettes, their placement into cassettes, and their alignment, as well as their simple transport from one location to another) is a matter of vital concern to the semiconductor industry.

Most known methods of transporting individual silicon wafers involve contact between (a) the underside of the wafer and (b) solid support surfaces or air jets which are likely to contain solid particles. For example, WO-A-8,404,739 describes apparatus for simultaneously rotating all the silicon wafers in a cassette so that the flats on all the wafers are in a desired orientation. These methods can damage the wafer.

GB-A-2171978 describes a computer-controlled robotic arm for lateral transportation of an individual wafer; the arm comprises three coplanar, parallel, resiliently mounted fingers, the centre finger being longer than the two outer fingers and being movable relative to them so that a wafer can be grasped between fixed buttons mounted at the end of each finger.

This invention provides a method and apparatus for transporting an individual silicon wafer in which there is substantially no inherent danger of damaging or contaminating the working surface of the wafer. The term "transporting" is used herein in the broad sense indicated above to include any process in which the wafer undergoes directional and/or rotational movement.

This invention not only provides important advantages in the ease, reliability and speed with which wafers can be transported, in particular when alignment of the wafers is needed. In addition, since the invention substantially reduces or eliminates the possibility of damage to the underside of the wafer, it can be used with silicon wafers which have two working surfaces.

In one aspect, this invention provides a method of transporting an individual silicon wafer wherein the wafer is supported solely by means of wafer supports which (a) are in the form of wheels which can rotate in the plane of the wafer, and (b) contact the wafer only around the periphery thereof, thus eliminating the need to contact either of the surfaces of the wafer. A preferred method also includes the step of rotating at least one of the wafer supports by means of an electric motor so as to precisely locate an alignment marker which indicates the crystalline plane of the wafer.

In another aspect, this invention provides apparatus which is suitable for use in the method defined above and which comprises

(1) a mounting frame; and
(2) at least two wafer carriers

(a) each of which comprises a plurality of wafer supports which are in the form of wheels which are rotatable in the plane of the wafer, and

(b) which can be moved relative to each other between (i) a closed position in which a wafer to be transported can be supported solely by contact between the periphery of the wafer and the wafer supports and (ii) an open position in which a wafer to be transported can be passed freely between the wafer supports.

In one preferred embodiment, the apparatus includes means for determining when a wafer supported by the wafer supports is correctly aligned. In another preferred embodiment, the wafer carriers and frame are such that a cassette of wafers can be placed adjacent to the apparatus, together with a means for moving the cassette and the wafer carriers relative to each other, and the wafer carriers can then be used for successively transporting individual wafers from the cassette.

The invention is illustrated by the following drawings in which;

Figure 1 is a side view of an apparatus of the invention,

Figures 2 and 3 are plan views of the apparatus in Figure 1 at successive stages of its operations,

Figure 4 is a detailed view of part of Figure 1,

Figure 5 is a cut away plan view on line AA of Figure 1,

Figure 6 is a plan view of a part of the apparatus of Figure 1 modified to provide motorized rotation of the wafer,

Figure 7 is a perspective sketch of a multi cassette transport mechanism in association with apparatus of the invention, and

Figure 8 illustrates a preferred drive mechanism for controlling the motion of the wafer carriers in apparatus of the invention

Silicon wafers are generally in the form of circular discs having a diameter of, for example, about 10.2, 12.7, 15.25 or 20.3 cm (about 4, 5, 6 or 8 inches), and having on the periphery thereof a flat or a notch which indicates the crystalline axis of the silicon. Many of the treatments to which silicon wafers are subjected are critically dependent on alignment. There is, therefore, a need for transport systems which align the wafer very precisely, or which check or maintain such alignment. One of the advantages of the present invention is that it makes it very simple to check whether a wafer has a desired alignment, and if it does not, to move the wafer laterally and/or rotationally into a desired alignment. The present invention will, therefore, chiefly be described by reference to methods and apparatus in which the transport of the wafer includes alignment thereof. It will be understood, however, that where appropriate, exemplary and preferred features of the invention are applicable to all forms of wafer transport. Similarly, where an exemplary or preferred feature is specifically described in a particular context or in combination with one or more particular features, such an exemplary or preferred feature can where appropriate also be used in other contexts and in combination with one or more other features described elsewhere in this specification.

In one preferred method in which a wafer is aligned,

(a) the wafer supports comprise first and second pairs of wheels which are rotatable in the plane of the wafer, the plane containing the axes of the wheels in the first pair is maintained parallel to the plane containing the axes of the wheels in the second pair, and the center of the wafer lies between the two pairs of wheels, and

(b) the first and second pairs of wheels are urged towards each other and thereby align the wafer so that its center lies on the line joining (a) the mid point of a line joining the axes of the wheels of the first pair in the plane of the disc and (b) the mid point of a line joining the axes of the wheels of the second pair in the plane of the disc.

When this method is used with a wafer having an alignment flat on its periphery and one of the wheels contacts the flat, the wafer will not only be aligned laterally but also will be rotated so that it is aligned rotationally.

Other methods can be employed wherein the desired rotational alignment of the wafer can be brought about by combining the alignment discontinuity on the periphery of a wafer with directional forces applied to the wafer by the wafer support means. Such directional forces (and the other directional forces referred to herein) can be generated by springs, preferably constant force extension springs, by hydraulic pressure, by pneumatic pressure (in which, for example, the air pressure in a cylinder can be adjusted to achieve a desired force) or otherwise. However, rotational alignment in this way is difficult or impossible when the discontinuity is very small (e.g. in the form of an alignment notch) or non-existent, and is of limited value when the wafers are not supplied in an approximately pre-aligned orientation, e.g. within 10° of the desired alignment. In such circumstances, it is preferred to use a motor, preferably an electric motor, to drive at least one of the wafer supports to effect or assist rotation of the wafer into a desired alignment. The motor can be coupled to at least one wheel, preferably at least two wheels, which bear against the periphery of the device, preferably via an elastomeric coating on the bearing surface of the wheel. However the desired rotational alignment is achieved, a sensor can be used to determine when the wafer is aligned. Any suitable physical, optical, electrical or other sensor can be used. For a notched wafer, a pin which is smaller than the notch can be urged against the periphery of the wafer and will enter the notch when alignment has been achieved. When a motor is used to rotate the wafer, it is important that it should be stopped as rapidly as possible after the sensor detects alignment. We have found it useful, when using an electric motor, to employ a magnetic brake or a control circuit which reverses the direction of current flow through the motor for a very short time after the sensor determines that the wafer is correctly aligned.

The wafer supports used in this invention are wheels which are rotatable in the plane of the wafer. The wheels can be spaced regularly or irregularly around the wafer and can be biased to assist in achieving desired alignment, e.g. for flat finding as described above or simply biassed in a radial direction. When the wafer is rotated with the aid of a motor, preferably one or more of the support wheels are rotated by the motor. The wheels preferably comprise elastomeric portions (or tires) which bear against the wafer, thus cushioning the wafer against physical and electrical damage. Preferably at least some of the wheels comprise flanges which are inclined to the axis of rotation of the wheel so that when the wafer carriers move from the open position to the closed position with a wafer between the wafer supports, the wafer moves up the flange in a direction at right angles to the plane of the wafer. Such upward movement can be accompanied by lateral movement to align the wafer laterally. When the wafer is horizontal a single flange on the lower side of the wheel is appropriate. When the wafer is vertical, a flange each side of the wheel is preferred.

In addition to the mounting frame and the wafer carriers, the apparatus of the invention preferably also comprises

(3) closing means which continuously and resiliently urges the wafer carriers towards the closed position, and

(4) motion-controlling means which (i) when the wafer carriers are in the open position, can overcome the force exerted by the closing means, and (ii) can be operated to permit the wafer carriers to move in a controlled manner into the closed position.

Silicon wafers are brittle and it is important to minimize the impact of the wafer supports against the periphery of the wafer. We have found that for this and other purposes, for example to permit minimum overall transport times without danger of accidentally releasing the wafer, it is desirable to control the linear movement of the wafer carriers in a cyclic fashion, preferably so that the supports approach the edge of the wafer at a very low speed. This can be achieved in any suitable way, for example through the use of a magnetic clutch which is activated when the wafer is properly located. However, we have found that a simple and reliable method of achieving this result is to drive the motion-controlling means for the wafer carrier in a cyclic manner, preferably in a cycloid manner achieved by translating the linear motion of a gear (or other) motor by means of a crank and a connecting rod, for example as described below in connection with Figure 8. In the same way, a reduction of the linear speed at which the wafer is transported can be achieved at one or more intermediate points along, and/or at the end of, a delivery route, e.g. from a cassette to a work station. At such intermediate points, the wafer can for example be viewed for identification marks, or the transport can be interrupted for a desired period, e.g. for a few seconds while the wafer is marked with a laser. Suitable cyclic driving can provide, for example, ramped sinusoidal acceleration and deceleration at both ends of a route, thus facilitating precise positioning of the wafer at the limits of the route.

As briefly noted above, the invention is particularly useful for transporting an individual wafer from a stack of wafers stored in a cassette. For this purpose, the apparatus of the invention preferably comprises two wafer carriers, each of which comprises

(a) a yoke which is slidably mounted on the frame,

(b) a riser which is secured to the yoke and extends outwardly from the yoke for a distance greater than the corresponding dimension, i.e. height or width, of the cassette; and

(c) a presenter which is secured to the riser and on which at least two of the wheels are mounted; the presenters and the wheels mounted thereon being thin enough to fit between the adjacent wafers in the cassette when the wafer carriers are moved from the open position to the closed position.

Such apparatus can be used merely to align the wafer and then to replace it in the cassette, or it can be used to deliver the wafer to a location outside the cassette, optionally aligning the wafer before, during or after the lianar movement of the wafer. For such delivery, the apparatus preferably further comprises

(6) means for moving the wafer carriers between (i) a pick-up location at which a wafer in the cassette can be picked up and (ii) a release location at which a wafer carried by the wafer carriers is completely outside the cassette and at which the wafer carriers can be moved into the open position to release the wafer.

The yoke carrying the wheels can be configured with horizontal or vertical support structure. With a vertical support structure, it is possible to provide the necessary clearance to transport cassettes laterally (horizontally and perpendicular to the presenter motion) through the yoke/presenter mechanism when it is in the open position. This makes it possible to line up one or more additional cassettes to allow continuous machine operation. "Processed" cassettes, not located at the elevator "work" station, can then be exchanged with "unprocessed" cassettes during normal machine operation. If the presenter structure is configured horizontally a more compact mechanism can be designed but it is restricted to single cassette operation.

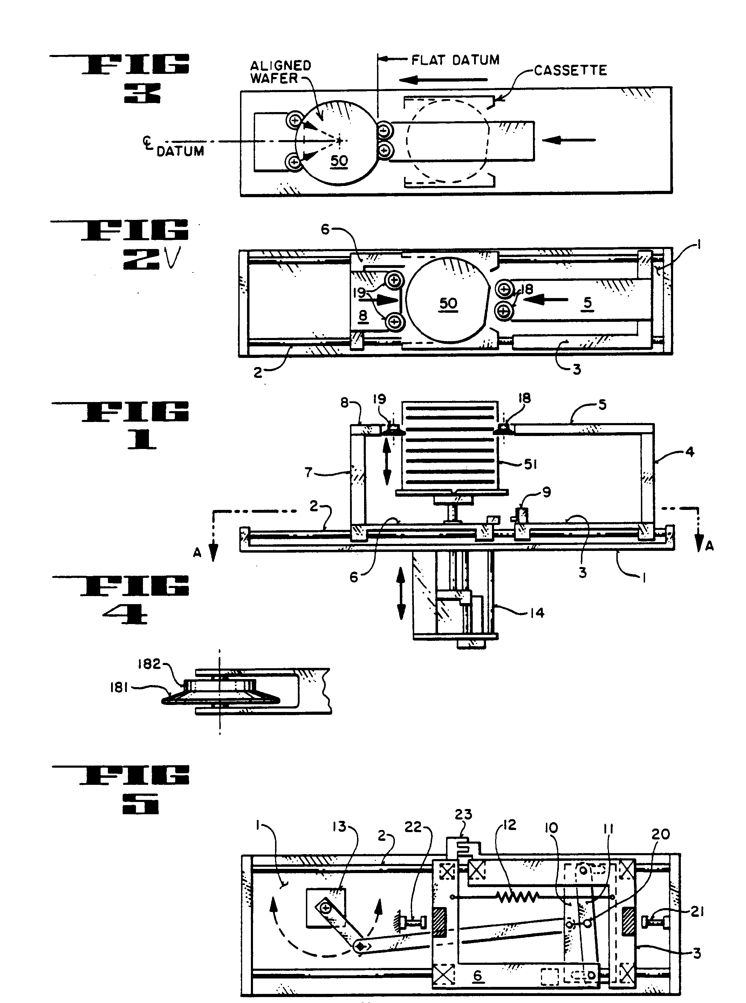

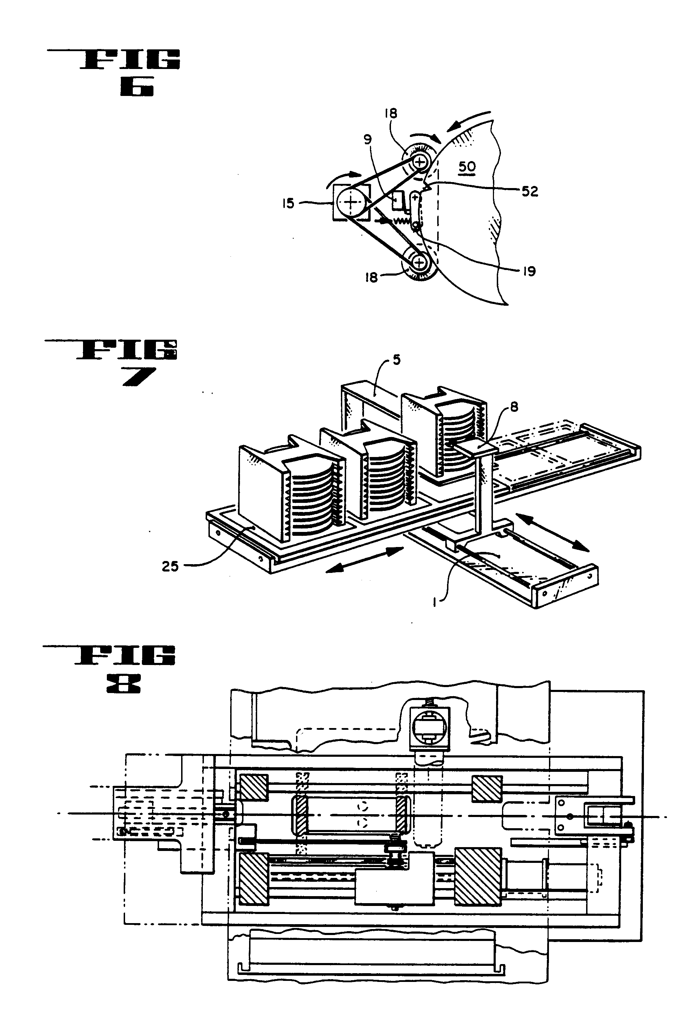

Referring now to Figures 1 to 5 of the drawing, these show preferred apparatus for laterally and rotationally aligning wafers 50 which have been approximately prealigned in a cassette 51 and which have an alignment flat on the periphery thereof. The apparatus comprises;

a mounting frame 1 to which are secured fixed linear slides 2;

a first wafer carrier which comprises (a) a first yoke 3 which slides with a linear motion along the slides 2, (b) a first riser 4 which is secured to the yoke 3 and which is tall enough to reach the top slot of a cassette whose supporting platform is above the sliding parts of the yoke, (c) a first presenter 5 which is secured to the riser 4, and (d) two flanged wheels 18, each of which has a flange 181 and an elastomeric driving surface 182, which are mounted on the presenter 5 and which are freely rotatable in the same plane as the water, and which are shown in greater detail in Figure 4;

a second wafer carrier which comprises (a) a second yoke 6 which slides with a linear motion along the same slides as (or slides parallel to those used by) the first yoke, (b) a second riser 7 which is secured to the yoke 6 and which is as tall as the first riser, (c) a second presenter 8 which is secured to the riser 7, and (d) two flanged wheels 19 which are identical to the wheels 18, which are mounted on the presenter 8, and which are rotatable in the same plane as the wafer;

a sensor 9 which indicates when the wafer is precisely aligned;

a slotted plate 10 which slides on the same slides as (or slides parallel to those used by) the yokes, and is attached to a linear actuator 13 and, through the slots, to each of the yokes, the slots being sized and positioned to allow limited relative motion of the yokes between the open and closed positions;

a lever 11 which is attached at each end to one of the yokes and which has a cam follower bearing 20 fixed thereto and aligned with fixed stops 21 and 22 (alternatively a flexure member or a tension link attached at one end of the lever can be used in place of the cam follower);

a tension spring 12 which is attached to the yokes and pulls them towards each other with a light and controlled force which is sufficient to hold a wafer placed between the flanged wheels without causing damage to the wafer;

a linear actuator 13 which is secured to the lever 11 and which, in combination with the spring 12 and the tops 21 and 22, controls the movement of the yokes relative to each other and relative to the mounting frame; and

an elevator 14 which is fixed to the mounting frame and can raise and lower the cassette so that each wafer stored in the cassette is in turn positioned into the plane of the presenters.

In operation of the apparatus shown in Figures 1-5, the cassette 51, loaded with approximately prealigned wafers 50, is placed on the elevator 14. The wafer carriers are in the open position. The bottom wafer is indexed by the elevator into the plane of the wheels on the presenters.

The linear actuator (13) starts its movement from the limit position in which the fulcrum of the lever (11) is hard against the stop (21), thus causing the spring (12) to be stretched and the presenters to be in the open position. As the linear actuator moves the slotted plate (10), this permits the lever (11) to rotate and the spring (12) to contract, thus moving the first yoke with its presenter towards the wafer. The second yoke (6) and presenter (8) are moved towards the wafer from the other side by the other end of the lever (11) under the same spring force. As the wheels 18 and 19 contact the wafer, the wafer is lifted by the tapered flanges of the wheels, and as the wheels close on the wafer, the flat is automatically aligned and the wafer is centered as the pairs of wheels move together under the spring force (12). When the wheel perimeters are in close contact with the wafer they stop moving closer together. At this point the alignment sensing switch (9) is activated indicating that the flat has been correctly located. If the flat is not located at this point, a control system switches off the linear actuator and sends a default signal. If the flat is correctly located, continued movement of the linear actuator causes the wafer to be moved out of the cassette. While the complete assembly of two yokes with their respective presenters and the wafer move out, the yokes are actually being held together by the spring (12) and held apart by the wafer. If the speed of the assembly is changed too rapidly, the inertial and frictional forces could overcome the spring tension and cause the wafer to be released during travel or cause too much compressive force to be applied to the wafer at the other end of the route thereby causing damage. To avoid this, a magnetic or similar brake (23) can be used, to lock the yokes in their relative positions when triggered by the sensing switch (9).

The presenter and supporting yoke, riser assemblies can be constructed with the necessary clearances to allow cassettes located on platforms to be transported laterally into and out of the presenter work station. The cassette transporting mechanism can be automated to allow continuous machine operation while "processed" cassettes are exchanged by an operator or robot cassette loader. When such a cassette, with platform, is positioned in the work station the elevator engages and lifts the platform to index each wafer in turn into the operating plane of the presenter.

Referring now to Figure 6, this shows the use of a pin 19 as an alignment sensor for a wafer 50 having an alignment notch 52. The pin 19 is spring-loaded against the periphery of the wafer 50 and enters the notch when the wafer is aligned. Also shown in Figure 6 is a motor 15 which is coupled to flanged wheels 18 for rotating the wafer 50 into the desired alignment. When the pin 19 enters the notch 52, it activates a detector switch 9 which disconnects the motor 15.

Referring now to Figure 7, this shows how a plurality of cassettes mounted on a platform 25 can be fed successively to an apparatus as shown in figures 1 to 5.

Referring now to Figure 8, this shows how a cycloid drive means can be fitted between an electric motor and a linear actuator, e.g. as shown in Figure 5, to provide a sinusoidal pause at the pick-up location, at the release location and at an intermediate location, with sinusoidally ramped acceleration either side of each pause. This is achieved by a cycloid drive mechanism which is driven at a constant speed by a motor-driven lead screw (or like device). The cycloid drive mechanism comprises a connecting rod which is attached at one end to the second yoke and at the other to a crank attached to a rotatable pinion mounted in bearings in the drive housing. It is thus moved along a toothed rack that causes it and the crank to rotate as the drive housing is moved. The crank pin is located at a radius the same as (or close to) the radius of the pinion, so that it moves along a cycloid path (similar to the valve on a bicycle wheel). The crank pin is arranged to rotate through two complete revolutions during its stroke, and thus provides sinusoidal ramped acceleration to a maximum speed at 1/4 stroke then reducing speed to a full stop at 1/2 stroke, where the wafer is picked up followed by acceleration up to full speed at 3/4 stroke, then smooth deceleration to zero speed at the end of stroke. By operating the motor "stop" switch close to this position, extremely accurate positioning is achieved.

## Claims

1. A method of transporting an individual silicon wafer (50) which is in the form of a generally circular disc having a principal plane, a periphery and a center, which method comprises transporting the wafer while it is supported solely by means of wafer supports which contact the wafer only around the periphery thereof, characterized in that the wafer supports are in the form of wheels (18,19) which are rotatable in the principal plane of the wafer.

2. A method according to Claim 1 characterized in that, while the wafer (50) is supported by the wafer support whells, at least one of the rotatable wheels (18,19) is rotated by means of an electric motor until the wafer has a desired rotational alignment.

3. A method according to Claim 1 or 2 characterized in that
   (a) the wafer supports comprise first and second pairs of wheels (18,19) which are rotatable in the principal plane of the wafer (50), the wheels of the first pair of wheels having axes of rotation which lie in a first plane and the wheels of the second pair of wheels having axes of rotation which lie in a second plane; the first plane is maintained parallel to the second plane; and the center of the wafer lies between the two pairs of wheels; and
   (b) the first and second pairs of wheels (18,19) are urged towards each other and thereby align the wafer so that its center lies on the line joining (a) the mid point of a line joining the axes of the wheels of the first pair in the principal plane of the wafer and (b) the mid point of a line joining the axes of the wheels of the second pair in the principal plane of the wafer.

4. Apparatus for transporting an individual silicon wafer which is in the form of a generally circular disc having a principal plane, a periphery and a center, said apparatus comprising a movable wafer carrier and, mounted on the carrier, a plurality of wafer supports which can be moved relative to each other between a closed position in which a wafer can be supported solely by contact between the periphery of the wafer and the wafer supports and an open position in which a wafer can be placed between the wafer supports, characterized in that said apparatus comprises
   (1) a mounting frame (1); and
   (2) at least two wafer carriers
      (a) each of which comprises a plurality of wafer supports which are in the form of wheels (18,19) which are rotatable in the principal plane of the wafer (50), and
      (b) which are movably mounted on the frame (1) so that they can be moved relative to each other between (i) a closed position in which a wafer to be transported can be supported solely by contact between the periphery of the wafer and the wafer supports and (ii) an open position in which a wafer to be transported can be passed freely between the wafer carriers.

5. Apparatus according to Claim 4 characterized in that at least some of the wafer support wheels (18,19) comprise flanges (181) which are inclined to the axis of rotation of the wheel so that when the wafer carriers move from the open position to the closed position with a wafer between the wafer supports, the wafer moves up the flanges (181) in a direction at right angles to the principal plane of the wafer (50).

6. Apparatus according to Claim 4 or 5 characterized in that it further comprises
   (3) closing means (12) which continuously and resiliently urges the wafer carriers towards the closed position, and
   (4) motion-controlling means (13) which (i) when the wafer carriers are in the open position, can overcome the force exerted by the closing means (12), and (ii) can be operated to permit the wafer carriers to move in a controlled manner into the closed position.

7. Apparatus according to Claim 6 characterized in that it further comprises
   (5) an electric motor which drives the motion-controlling means in a cyclic manner such that the linear speed of the motion-controlling means is relatively low as the wafer carriers move into the closed position.

8. Apparatus according to Claim 5, 6 or 7 which is adapted to transport an individual wafer (50) from a stack of spaced-apart, parallel wafers in a cassette (51), characterized in that there are two wafer carriers, each of said wafer carriers comprising
   (a) a yoke (3,6) which is slidably mounted on the mounting frame (1),
   (b) a riser (4,7) which is secured to the yoke (3,6) and extends outwardly from the yoke for a distance greater than a corresponding dimension of the cassette, and
   (c) a presenter (5,8) which is secured to the riser (4,7) and on which at least two of the wafer support wheels (18,19) are mounted;
   the presenters and the wafer support wheels mounted thereon being thin enough to fit between adjacent wafers in the cassette when the wafer carriers are moved from the open position to the closed position.

9. Apparatus according to Claim 8 which is adapted to extract a wafer from a cassette and to deliver it to a location outside the cassette, characterized in that it further comprises

(6) means (2,13,21,22) for moving the wafer carriers between (i) a pick-up location at which a wafer in the cassette can be picked up and (ii) a release location at which a wafer carried by the wafer carriers is completely outside the cassette and at which the wafer carriers can be moved into the open position to release the wafer.

10. Apparatus according to any of Claims 4 to 9 characterized in that it further comprises

(7) a sensor (9) for determining when a wafer (50) supported by the wheels (18,19) has a desired rotational alignment, and

(8) an electric motor which can be operated to drive at least two of the wheels (18,19) when a wafer (50) supported by the wheels is not correctly rotationally aligned, and means for stopping the motor when the sensor determines that the wafer is correctly rotationally aligned.

**Patentansprüche**

1. Verfahren zum Transportieren eines einzelnen Siliziumplättchens (50), das in der Form einer im allgemeinen kreisförmigen Scheibe vorliegt mit einer Hauptebene, einem Umfang und einer Mitte, welches Verfahren Transportieren des Plättchens aufweist, während es ausschließlich mittels Plättchenträger getragen wird, die das Plättchen nur um dessen Umfang berühren, dadurch gekennzeichnet, daß die Plättchenträger in Form von Rädern (18, 19) gebildet sind, die drehbar in der Hauptebene des Plättchens liegen.

2. Verfahren nach Anspruch 1, dadurch gekennzeichnet, daß, während das Plättchen (50) durch die Plättchenträgerräder getragen wird, mindestens eines der drehbaren Räder (18, 19) mittels eines elektrischen Motors gedreht wird, bis das Plättchen eine gewünschte Rotationsausrichtung aufweist.

3. Verfahren nach Anspruch 1 oder 2, dadurch gekennzeichnet, daß

(a) die Plättchenträger ein erstes und zweites Paar von Rädern (18, 19) aufweist, die drehbar in der Hauptebene des Plättchens (50) liegen, die Räder des ersten Paares von Rädern Rotationsachsen aufweisen, die in der ersten Ebene liegen, und die Räder des zweiten Paares von Rädern Rotationsachsen aufweisen, die in einer zweiten Ebene liegen; die erste Ebene wird parallel zu der zweiten Ebene gehalten und die Mitte des Plättchens liegt zwischen den zwei Paaren von Rädern; und

(b) das erste und zweite Paar von Rädern (18, 19) zueinander gedrückt werden und dabei das Plättchen so ausrichten, daß seine Mitte auf der Linie liegt, die (a) den Mittelpunkt einer Linie, die die Achsen der Räder des ersten Paares in der Hauptebene des Plättchen verbindet, und (b) den Mittelpunkt einer Linie, die die Achsen der Räder des zweiten Paares in der Hauptebene des Plättchens verbindet, verbindet.

4. Einrichtung zum Transportieren eines einzelnen Siliziumplättchens, das in der Form einer im allgemeinen kreisförmigen Scheibe vorliegt, die eine Hauptebene, einen Umfang und eine Mitte aufweist, wobei die Einrichtung eine bewegbare Plättchenunterstützung und eine auf der Unterstützung angebrachte Mehrzahl von Plättchenträgern aufweist, die relativ zueinander zwischen einer geschlossenen Position, in der ein Plättchen ausschließlich durch den Kontakt zwischen dem Umfang des Plättchens und den Plättchenträger getragen werden kann, und einer offenen Position, in der ein Plättchen zwischen die Plättchenträger angeordnet werden kann, bewegt werden können, dadurch gekennzeichnet, daß die Einrichtung aufweist

(1) einen Montierungsrahmen (1) und

(2) mindestens zwei Plättchenunterstützungen,

(a) von denen jede eine Mehrzahl von Plättchenträgern aufweist, die in der Form von Rädern (18, 19) vorliegen, die drehbar in der Hauptebene der Plättchen (50) liegen, und

(b) die bewegbar auf dem Rahmen (1) so angebracht sind, daß sie relativ zueinander zwischen (i) einer geschlossenen Position, in der ein zu transportierendes Plättchen ausschließlich durch den Kontakt zwischen dem Umfang des Plättchens und den Plättchenträgern getragen werden kann, und (ii) einer offenen Position, in der ein zu transportierendes Plättchen frei zwischen den Plättchenunterstützungen durchgehen kann, bewegt werden können.

5. Einrichtung nach Anspruch 4, dadurch gekennzeichnet, daß mindestens einige der Plättchenträgerräder (18, 19) Flansche (181) aufweisen, die zu der Rotationsachse des Rades so geneigt sind, daß, wenn sich die Plättchenunterstützungen aus der offenen Position zu der geschlossenen Position bewegen, wobei ein Plättchen zwischen den Plättchenträgern ist, sich das Plättchen aufwärts entlang der Flansche (181) in eine Richtung in rechten Winkeln zu der Hauptebene des Plättchens (50) bewegt.

6.  Einrichtung nach Anspruch 4 oder 5, dadurch gekennzeichnet, daß sie weiter aufweist
    (3) eine Schließeinrichtung (12), die kontinuierlich und federnd die Plättchenunterstützungen in die geschlossene Position drücken und
    (4) eine Bewegungssteuereinrichtung (13), die, (i) wenn die Plättchenunterstützungen in der offenen Position sind, die durch die Schließeinrichtung (12) ausgeübte Kraft überwinden kann, und (ii) betätigt werden kann zum Ermöglichen der Plättchenunterstützungen, sich auf eine gesteuerte Weise in die geschlossene Position zu bewegen.

7.  Einrichtung nach Anspruch 6, dadurch gekennzeichnet, daß sie weiter aufweist
    (5) einen Elektromotor, der die Bewegungssteuereinrichtung auf zyklische Weise so antreibt, daß die lineare Geschwindigkeit der Bewegungssteuereinrichtung relativ klein ist, wenn sich die Plättchenunterstützungen in die geschlossene Position bewegen.

8.  Einrichtung nach Anspruch 5, 6 oder 7, die zum Transportieren eines individuellen Plättchens (50) von einem Stapel von in einem Abstand voneinander angeordneten parallelen Plättchen in einer Kassette (51) angepasst ist, dadurch gekennzeichnet, daß es zwei Plättchenunterstützungen gibt, wobei jede Plättchenunterstützung aufweist
    (a) ein Joch (3, 6) das gleitend auf dem Montierungsrahmen (1) angebracht ist,
    (b) ein aufsteigendes Teil (4, 7) das an dem Joch (3, 6) befestigt ist und sich auswärts von dem Joch um eine Distanz erstreckt, die größer als eine entsprechende Abmessung der Kassette ist, und
    (c) einen Vorleger (5, 8), der an dem aufsteigenden Teil (5, 7) befestigt ist und auf dem mindestens zwei der Plättchenträgerräder (18, 19) angebracht sind;
    wobei die darauf angebrachten Vorleger und Plättchenträgerräder dünn genug sind, um zwischen benachbarte Plättchen in der Kassette zu passen, wenn die Plättchenunterstützungen von der offenen Position zu der geschlossenen Position bewegt werden.

9.  Einrichtung nach Anspruch 8, die zum Herausziehen eines Plättchens aus einer Kassette und zum Liefern desselben an eine Position außerhalb der Kassette angepasst ist, dadurch gekennzeichnet, daß sie weiter aufweist
    (6) eine Einrichtung (2, 13, 21, 22) zum Bewegen der Plättchenunterstützungen zwischen (i) einer Aufnahmeposition an der ein Plättchen in der Kassette aufgenommen werden kann, und (ii) einer Freigabeposition, an der ein von den Plättchenunterstützungen getragenes Plättchen vollkommen außerhalb der Kassette ist und an der die Plättchenunterstützungen in die offene Position zum Freigeben des Plättchens bewegt werden können.

10. Einrichtung nach einem der Ansprüche 4 bis 9, dadurch gekennzeichnet, daß sie weiter aufweist
    (7) einen Sensor (9) zum Bestimmen, wann ein von den Rädern (18, 19) getragenes Plättchen die gewünschte drehungsmäßige Ausrichtung aufweist, und
    (8) einen Elektromotor, der zum Antreiben von mindestens zwei der Räder (18, 19) betätigt werden kann, wenn ein von den Rädern getragenes Plättchen (50) nicht richtig rotationsmäßig ausgerichtet ist, und eine Einrichtung zum Anhalten des Motors, wenn der Sensor bestimmt, daß das Plättchen richtig rotationsmäßig ausgerichtet ist.

**Revendications**

1.- Procédé pour transporter une tranche de silicium individuelle (50) qui a la forme d'un disque dans l'ensemble circulaire présentant un plan principal, une périphérie et un centre, ce procédé impliquant le transport de la tranche tandis qu'elle n'est soutenue que par des supports de tranche qui ne sont en contact avec la tranche qu'autour de sa périphérie, caractérisé en ce que les supports de tranche ont la forme de galets (18, 19) qui peuvent tourner dans le plan principal de la tranche.

2.- Procédé suivant la revendication 1, caractérisé en ce que, tandis que la tranche (50) est soutenue par les galets de support de tranche, au moins un des galets rotatifs (18, 19) est entraîné en rotation au moyen d'un moteur électrique jusqu'à ce que la tranche présente un alignement en rotation souhaité.

3.- Procédé suivant la revendication 1 ou 2, caractérisé en ce que
    (a) les supports de tranche comprennent une première et une seconde paire de galets (18, 19) qui peuvent tourner dans le plan principal de la tranche (50), les galets de la première paire de galets comportant des axes de rotation qui sont disposés dans un premier plan et les galets de la seconde paire de galets comportant des axes de rotation qui sont disposés dans un second plan; le premier plan est maintenu parallèle au second plan; et le centre de la tranche est disposé entre les deux paires de galets; et

(b) la première et la seconde paire de galets (18, 19) sont sollicitées l'une vers l'autre et alignent ainsi la tranche de telle sorte que son centre soit situé sur la ligne reliant (a) le point médian d'une ligne reliant les axes des galets de la première paire dans le plan principal de la tranche et (b) le point médian d'une ligne reliant les axes des galets de la seconde paire dans le plan principal de la tranche.

4.- Appareil destiné à transporter une tranche de silicium individuelle qui a la forme d'un disque dans l'ensemble circulaire présentant un plan principal, une périphérie et un centre, cet appareil comprenant un porte-tranche mobile et, montés sur le porte-tranche, plusieurs supports de tranche qui peuvent être déplacés l'un par rapport à l'autre entre une position de fermeture dans laquelle une tranche peut être supportée uniquement par contact entre la périphérie de la tranche et les supports de tranche et une position d'ouverture dans laquelle une tranche peut être placée entre les supports de tranche, caractérisé en ce que l'appareil comprend :

(1) un bâti de montage (1); et

(2) au moins deux porte-tranche

(a) chacun de ces porte-tranche comprenant plusieurs supports de tranche qui ont la forme de galets (18, 19) pouvant tourner dans le plan principal de la tranche (50), et

(b) qui sont montés de façon mobile sur le bâti (1) de manière à pouvoir être déplacés l'un par rapport à l'autre entre (i) une position de fermeture dans laquelle une tranche à transporter peut n'être supportée que par contact entre la périphérie de la tranche et les supports de tranche et (ii) une position d'ouverture dans laquelle une tranche à transporter peut passer librement entre les porte-tranche.

5.- Appareil suivant la revendication 4, caractérisé en ce qu'au moins certains des galets de support de tranche (18, 19) comprennent des collerettes (181) qui sont inclinées par rapport à l'axe de rotation du galet, de sorte que lorsque les porte-tranche se déplacent de la position d'ouverture vers la position de fermeture et qu'une tranche est présente entre les supports de tranche, la tranche monte le long des collerettes (181) dans un sens perpendiculaire au plan principal de la tranche (50).

6.- Appareil suivant la revendication 4 ou 5, caractérisé en ce qu'il comprend, en outre,

(3) un moyen de fermeture (12) qui sollicite continuellement et élastiquement les porte-tranche vers la position de fermeture, et

(4) un moyen de commande de mouvement (13) qui (i) lorsque les porte-tranche sont dans la position d'ouverture, peut surmonter la force exercée par le moyen de fermeture (12) et (ii) peut être actionné pour permettre aux porte-tranche de se déplacer d'une manière réglée dans la position de fermeture.

7.- Appareil suivant la revendication 6, caractérisé en ce qu'il comprend, en outre,

(5) un moteur électrique qui entraîne le moyen de commande de mouvement d'une manière cyclique de façon telle que la vitesse linéaire du moyen de commande de mouvement soit relativement basse lorsque les porte-tranche se déplacent dans la position de fermeture.

8.- appareil suivant la revendication 5, 6 ou 7, qui est à même de transporter une tranche individuelle (50) à partie d'une pile de tranches parallèles espacées dans une cassette (51), caractérisé en ce qu'il comporte deux porte-tranche, chaque porte-tranche comprenant :

(a) un étrier (3, 6) qui est monté à coulissement sur le bâti de montage (1),

(b) une colonnette (4, 7) qui est fixée à l'étrier (3, 6) et s'étend vers l'extérieur à partir de cet étrier sur une distance supérieure à une dimension correspondante de la cassette, et

(c) un présenteur (5, 8) qui est fixé à la colonnette (4, 7) et sur lequel au moins deux des galets de support de tranche (18, 19) sont montés;

les présenteurs et les galets de support de tranche montés sur ceux-ci étant suffisamment minces pour s'ajuster entre des tranches adjacentes dans la cassette lorsque les porte-tranche sont déplacés de la position d'ouverture vers la position de fermeture.

9.- Appareil suivant la revendication 8, qui est à même d'extraire une tranche d'une cassette et de la transférer vers un endroit situé en dehors de la cassette, caractérisé en ce qu'il comprend, en outre,

(6) des moyens (2, 13, 21, 22) pour déplacer les porte-tranche entre (i) un emplacement de saisie auquel une tranche dans la cassette peut être saisie et (ii) un emplacement de libération auquel une tranche supportée par les porte-tranche se trouve entièrement à l'extérieur de la cassette et auquel les porte-tranche peuvent être amenés dans la position d'ouverture pour libérer la tranche.

10.- Appareil suivant l'une quelconque des revendications 4 à 9, caractérisé en ce qu'il comprend, en outre,

(7) un capteur (9) pour déterminer qu'une tranche (50) supportée par les galets (18, 19) présente un alignement en rotation souhaité, et

(8) un moteur électrique qui peut être actionné pour entraîner au moins deux des galets (18, 19) si une tranche (50) supportée par les galets n'est pas correctement alignée en rotation, et un moyen pour arrêter le moteur si le capteur détermine que la tranche est correctement alignée en rotation.

EP 0 365 589 B1

**FIG 3**

ALIGNED WAFER  FLAT DATUM  CASSETTE

₡ DATUM

50

**FIG 2V**

6  1

19  18

8  50  5

2  3

**FIG 1**

8 19  18  5

7  51  4

2

A  9

A

6  3  1

6

**FIG 4**

14

182

181

**FIG 5**

1  13  2  22  23  12  10  11  20

21

6  3

10

**FIG 6**

**FIG 7**

**FIG 8**